# EUROPEAN PATENT APPLICATION

(11) **EP 2 141 918 A2**
(43) Date of publication of application: **06.01.2010**
(21) Application number: 09008210.8
(22) Date of filing: 23.06.2009
(51) Int. Cl.: H04N 5/44, H04N 5/46, H04N 5/50

(54) **Television tuner**

(30) Priority: 30.06.2008 JP 2008170936
(71) Applicant: Alps Electric Co., Ltd., Tokyo 145-8501 (JP)
(72) Inventor: Inoue, Ryoji, Tokyo, 145-8501 (JP)
(74) Representative: Klunker . Schmitt-Nilson . Hirsch

(57) **Abstract**

A television tuner capable of receiving digital television signals and analog television signals, comprising: a mixer circuit (17) converting the received television signals into signals of an intermediate-frequency band, and an intermediate-frequency tuning circuit (19) being connected to a rear end of the mixer circuit (17) and set to a tuning frequency corresponding to a reception channel, wherein the intermediate-frequency tuning circuit (17) includes: a first resonant circuit configured to have a first capacitance and to have a resonant frequency set in the intermediate-frequency band, and a second resonant circuit configured to have a second capacitance and to have a resonant frequency set substantially equal to that of the first resonant circuit, and wherein the first capacitance is smaller than the second capacitance.

## Description

### Cross Reference to Related Application

The present invention contains subject matter related to and claims priority to Japanese Patent Application No. 2008-170936 filed in the Japanese Patent Office on June 30, 2008, the entire contents of which are incorporated herein by reference.

### BACKGROUND

### 1. Technical Field

The present invention relates to a television tuner capable of receiving digital television signals and analog television signals.

### 2. Related Art

In the past, as a television tuner of receiving digital television signals and analog television signals, it has known to switch the circuit configuration in an intermediate-frequency tuning circuit in response to the received television signals (for example, see Japanese Unexamined Patent Application Publication No. 2000-350107). The intermediate-frequency tuning circuit of the television tuner is constituted by a parallel resonant circuit and a damper circuit. The parallel resonant circuit and the damper circuit are configured to be capable of connected or disconnected by a switch. Then, the damper circuit and the parallel resonant circuit are cut off in receiving the analog television signals, and the damper circuit and the parallel resonant circuit are connected in receiving the digital television signals, so that the circuit configuration in the intermediate-frequency tuning circuit is configured to be switched so as to be suitable for the received television signals.

### SUMMARY

However, since the known intermediate-frequency tuning circuit of the television tuner is configured to connect the parallel resonant circuit and the damper circuit via the switch, there has been a problem that it increases in the number of components and grows in size, and the circuit configuration thereof becomes complex. When the intermediate-frequency tuning circuit is constituted by only the parallel resonant circuit to solve this problem, there has been a problem that if the parallel resonant circuit is configured to be suitable for receiving either one of the digital television signals or the analog television signals, the performance of the other signal reception becomes degraded.

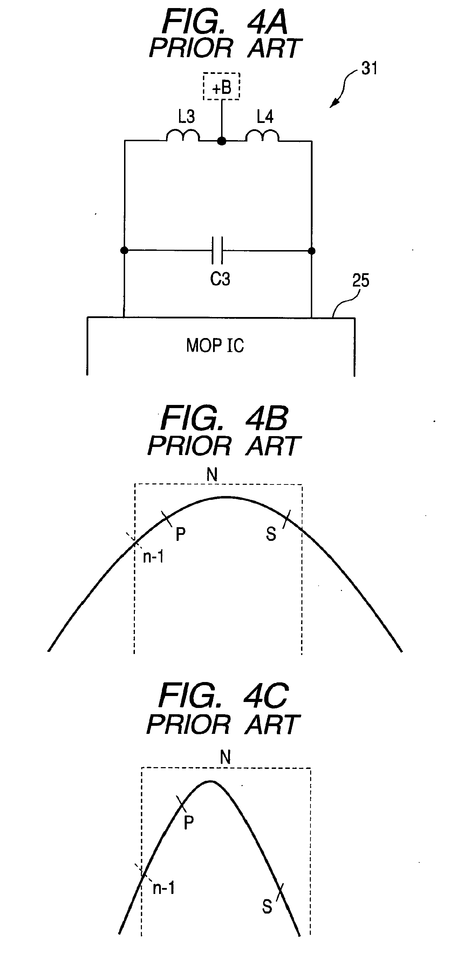

In particular, when a parallel resonant circuit 31 is constituted by two serial-connected inductors L3 and L4, and a capacitor C3 connected in parallel to the two inductors L3 and L4 as shown in Fig. 4A, if the sum total of inductance values of the two inductors L3 and L4 is large and the capacitance of the capacitor C3 is small, then frequency selectivity Q becomes lower and the bandwidth becomes wider, thus resulting in the smooth pass characteristic, as shown in Fig. 4B. In this case, the ideal pass characteristic is exhibited in receiving the digital television signals, but the tolerance for an adjacent channel is deteriorated in receiving the analog television signals. On the other hand, if the sum total of inductance values of the two inductors L3 and L4 is small and the capacitance of the capacitor C3 is large, then frequency selectivity Q becomes higher and the bandwidth becomes narrower, thus resulting in the steep pass characteristic, as shown in Fig. 4C. In this case, the ideal pass characteristic is exhibited in receiving the analog television signals, but signals of the low-pass side and the high-pass side of a desired channel (channel bandwidth) are attenuated to a large extent in receiving the digital television signals, thereby degrading the receiving performance. In addition, N of Fig. 4 is indicative of a channel in receiving the digital television signals, and P, S and n-1 are indicative of a picture signal, a sound signal and an adjacent channel in receiving the analog television signals, respectively.

An advantage of some aspects of the invention is to provide a television tuner being capable of making the circuit configuration simple, and capable of receiving both digital television signals and analog television signals without degrading the receiving performance.

In an aspect of the embodiments of the invention, a television tuner capable of receiving digital television signals and analog television signals is provided. The television tuner may comprise a mixer circuit converting the received television signals into signals of an intermediate-frequency band, and an intermediate-frequency tuning circuit being connected to a rear end of the mixer circuit and set to a tuning frequency corresponding to a reception channel. In the television tuner, the intermediate-frequency tuning circuit may include a first resonant circuit configured to have a first capacitance and to have a resonant frequency set in the intermediate-frequency band, and a second resonant circuit configured to have a second capacitance and to have a resonant frequency set substantially equal to that of the first resonant circuit. In the television tuner, the first capacitance is preferably smaller than the second capacitance.

According to this configuration, since the resonant frequency of the first resonant circuit is substantially equal to the resonant frequency of the second resonant circuit and the first capacitance of the first resonant circuit is smaller than the second capacitance of the second resonant circuit, the first resonant circuit has lower frequency selectivity Q and wider bandwidth and thus the pass characteristic suitable for receiving the digital television signals, and also the second resonant circuit has higher frequency selectivity Q and the narrower bandwidth and thus the pass characteristic suitable for receiving the analog television signals. Therefore, since the intermediate-frequency tuning circuit has the pass characteristic which is a combination of the pass characteristic of the first resonant circuit suitable for receiving the digital television signals and the pass characteristic of the second resonant circuit suitable for receiving the analog television signals, it is possible to receive both digital television signals and analog television signals without degrading the receiving performance.

Further, since the intermediate-frequency tuning circuit is configured to be a combination of the first resonant circuit and the second resonant circuit, the intermediate-frequency tuning circuit can be downsized and the circuit configuration thereof can be also simplified by a reduction in the number of components, in comparison with the circuit configuration in the intermediate-frequency tuning circuit switched by a switch or the like.

In another aspect of the embodiments of the invention, the television tuner in which the mixer circuit has a pair of balance output terminals may be provided. In the television tuner, the first resonant circuit may be constituted by the first capacitance connected between the pair of balance output terminals, and a series-connected circuit of first and second inductors connected in parallel to the first capacitance, a connection point thereof between the first inductor and the second inductor being grounded in a high-frequency manner. In the television tuner, the second resonant circuit may be constituted by the first inductor, and the second capacitance connected in parallel to the first inductor.

According to this configuration, the first resonant circuit can be constituted by a first capacitive element, a first inductance element and a second inductance element, and the second resonant circuit can be constituted by the second capacitance and the first inductor. Further, since the first resonant circuit has a smaller capacitance than the second resonant circuit and has a larger inductance value than the second resonant circuit by an inductance value of the second inductor, the first resonant circuit has lower frequency selectivity Q and thus the pass characteristic suitable for the digital television signals. On the other hand, since the second resonant circuit has a larger capacitance than the first resonant circuit and has a smaller inductance value than the first resonant circuit by an inductance value of the second inductor, the second resonant has higher frequency selectivity Q and thus the pass characteristic suitable for the analog television signals. Therefore, it is possible to make the pass characteristic of the intermediate-frequency tuning circuit be the pass characteristic which is a combination of the pass characteristic suitable for receiving the digital television signals and the pass characteristic suitable for receiving the analog television signals

Further, since the first resonant circuit and the second resonant circuit use the first inductor in common, the number of components can be reduced.

In still another aspect of the embodiments of the invention, the television tuner in which an inductance value of the first inductor is smaller than an inductance value of the second inductor may be provided.

According to this configuration, since an inductance value of the first inductor is smaller than an inductance value of the second inductor, the second resonant circuit is constituted by the second capacitance having a large capacitance and the first inductor having a small inductance value, and therefore, frequency selectivity Q of the second resonant circuit can be made higher.

In still another aspect of the embodiments of the invention, the television tuner in which the second resonant circuit has a resistive element setting the frequency selectivity of the second resonant circuit may be provided.

According to this configuration, it is possible to adjust frequency selectivity Q of the second resonant circuit by changing a resistance value of the resistive element.

### BRIEF DESCRIPTION OF THE DRAWINGS

The disclosure and related embodiments will now be described, by way of example only, with reference to the accompanying drawings, in which:
Fig. 1 shows a block diagram of a television tuner, illustrating an embodiment of the television tuner according to the invention;
Fig. 2 shows a circuit configuration diagram of an IF tuning circuit, illustrating an embodiment of the television tuner according to the invention;
Fig. 3A shows a pass characteristic of a first resonant circuit, Fig. 3B shows a pass characteristic of a second resonant circuit, and Fig. 3C shows a pass characteristic of the IF tuning circuit, respectively, illustrating embodiments of the television tuner according to the invention; and
Fig. 4 shows a conventional example of the television tuner according to the invention.

### DESCRIPTION OF EXEMPLARY EMBODIMENTS

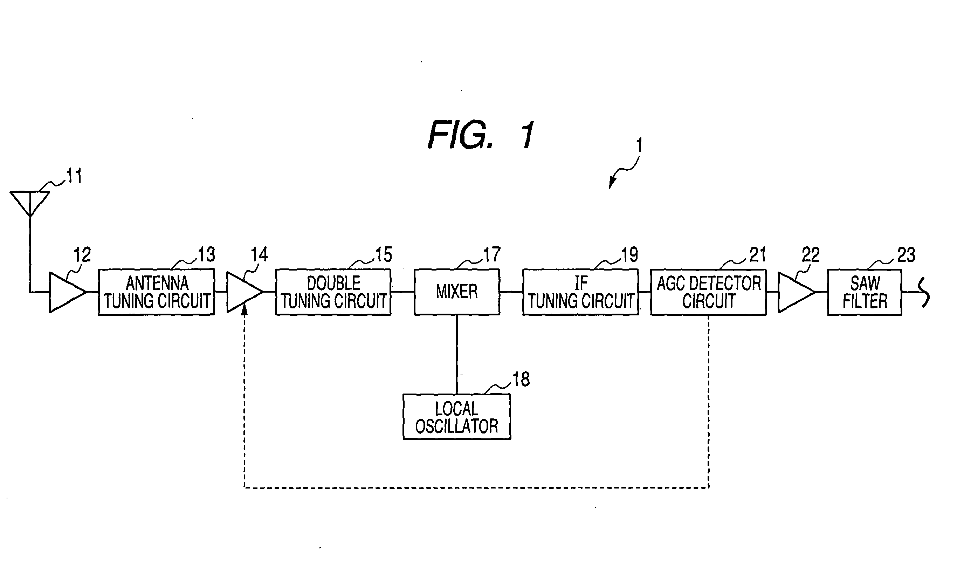

Fig. 1 shows a block diagram of a television tuner according to an embodiment of the invention.

As shown in Fig. 1, television signals received in an antenna element 11 are amplified in a broadband amplifier 12, and input to an antenna tuning circuit 13. The antenna tuning circuit 13 varies capacitances of a variable capacitive element (not shown) and sets tuning frequencies. The television signals passing through the antenna tuning circuit 13 are controlled to have constant outputs in an AGC amplifier 14, and input to a double tuning circuit 15. The double tuning circuit 15, similarly to the antenna tuning circuit 13, varies capacitances of a variable capacitive element (not shown) and sets tuning frequencies. The television signals passing through the double tuning circuit 15 are input to a mixer 17 along with locally-oscillated signals output from a local oscillator 18.

The television signals input to the mixer 17 are multiplied by the locally-oscillated signals output from a local oscillator 18 to be frequency-converted into intermediate frequency signals. At that time, the intermediate frequency signals to be generated consist of sum components and difference components of signals input from the double tuning circuit 15 and the locally-oscillated signals, but only necessary frequency components are taken out in an IF tuning circuit 19. The IF tuning circuit 19 will be described later.

The television signals passing through the IF tuning circuit 19 are input to an AGC detector circuit 21. The AGC detector circuit 21 controls the feedback of the AGC amplifier 14 in response to reception levels of the input television signals, thereby performing gain control of the AGC amplifier 14. The television signals passing through the AGC detector circuit 21 are amplified in an IF amplifier 22, and interfering waves are excluded in an SAW filter 23. Then, the television signals passing through the SAW filter 23 are input to a demodulator (not shown) via an amplifier.

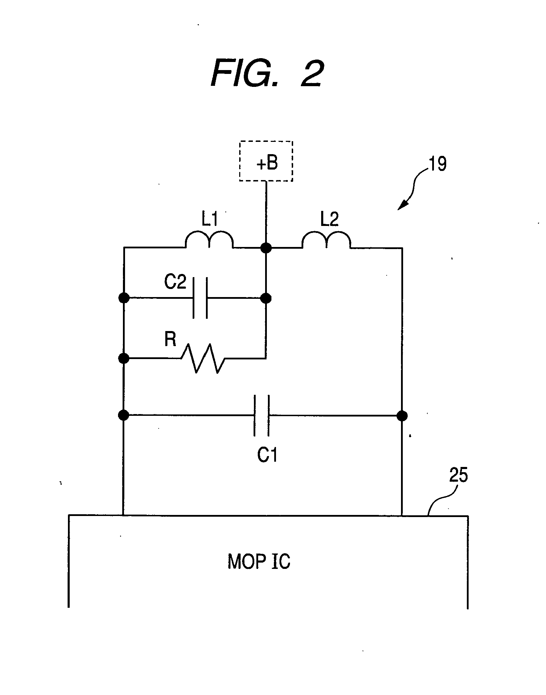

Next, the IF tuning circuit 19 which is a feature part of the invention will be described. Fig. 2 shows a circuit configuration diagram of the IF tuning circuit.

As shown in Fig. 2, the IF tuning circuit 19 is attached externally to an MOP integrated circuit 25 (hereinafter, referred to as MOP-IC) embedded with the mixer 17, the local oscillator 18, the AGC detector circuit 21 and the IF amplifier 22, and is comprised of a first inductor L1, a second inductor L2, a first capacitor C1, a second capacitor C2 and a bias resistor R. '

One terminal of a pair of balance output terminals of the MOP-IC 25 is connected to one end of the first inductor L1, and one end of the second inductor L2 is connected to the other end of the first inductor L1. The other terminal of the pair of balance output terminals of the MOP-IC 25 is connected to the other end of the second inductor L2, and the first capacitor C1 is connected in parallel to the first inductor L1 and the second inductor L2 between one end of the first inductor L1 and the other end of the second inductor L2.

The second capacitor C2 is connected in parallel to the first inductor L1 between one end and the other end of the first inductor L1, and the bias resistor R is connected in parallel to each of the first inductor L1 and the second capacitor C2 between one end and the other end of the second capacitor C2.

Further, a power source B is connected to a connection point of the other end of the first inductor L1 and one end of the second inductor L2, and a power source line is grounded in a high-frequency manner. In the MOP-IC 25, the power source B is supplied via the first inductor L1 and the second inductor L2. The first resonant circuit is constituted by the first inductor L1, the second inductor L2 and the first capacitor C1, and the second resonant circuit is constituted by the first inductor L1 and the second capacitor C2. In this way, the first resonant circuit and the second resonant circuit use the first inductor L1 in common, thus resulting in a reduction in the number of components.

Moreover, the IF tuning circuit is constituted so that a capacitance of the first capacitor C1 is smaller than a capacitance of the second capacitor C2, an inductance value of the first inductor L1 is smaller than an inductance value of the second inductor L2, and resonant frequencies of the first resonant circuit and the second resonant circuit are substantially identical to each other. That is, the first resonant circuit is constituted by a circuit having a small capacitance and a large inductance value, and the second resonant circuit is constituted by a circuit having a large capacitance and a small inductance value.

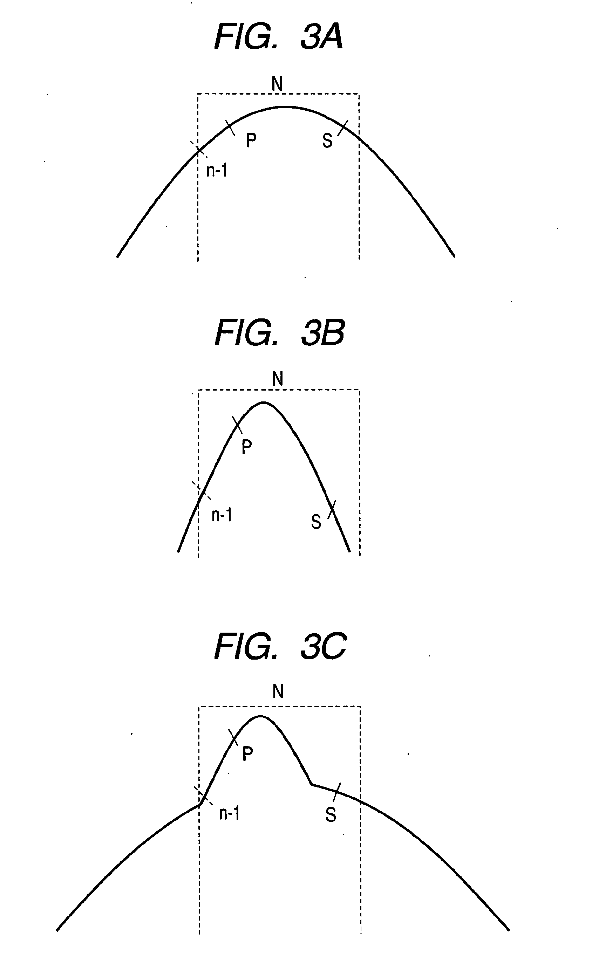

Next, the pass characteristic of the IF tuning circuit as mentioned above will be described. Fig. 3A shows a pass characteristic diagram of the first resonant circuit, Fig. 3B shows a pass characteristic diagram of the second resonant circuit, and Fig. 3C shows a pass characteristic diagram of the IF tuning circuit. In addition, N of Fig. 3 is indicative of a channel in receiving the digital television signals, and P, S and n-1 are indicative of a picture signal, a sound signal and an adjacent channel in receiving the analog television signals, respectively.

Since the first resonant circuit is constituted by a circuit having a small capacitance and a large inductance value, the first resonant circuit has lower frequency selectivity Q and wider bandwidth and thus the smooth pass characteristic, as shown in Fig. 3A. Therefore, in the first resonant circuit, the ideal pass characteristic can be obtained due to power of a desired channel becoming larger in receiving the digital television signals, but the tolerance for an adjacent channel is deteriorated in receiving the analog television signals.

Further, since the second resonant circuit is constituted by a circuit having a large capacitance and a small inductance value, the second resonant circuit has higher frequency selectivity Q and narrower bandwidth and thus the steep pass characteristic, as shown in Fig. 3B. Therefore, in the second resonant circuit, the ideal pass characteristic can be obtained due to the improved tolerance for an adjacent channel in receiving the analog television signals, but signals of the low-pass side and the high-pass side of a desired channel are attenuated to a large extent in receiving the digital television signals, thereby degrading the receiving performance.

On the other hand, the IF tuning circuit 19 which is a combination of the first resonant circuit and the second resonant circuit has the pass characteristic, as shown in Fig. 3C, such as a combination of the pass characteristics shown in Fig. 3A and Fig. 3B, in which the bandwidth is wide and a portion of smooth waveforms is steeply protruded. According to this configuration, power of a desired channel can be obtained in receiving the digital television signals, and the tolerance for an adjacent channel can be improved in receiving the analog television signals. In addition, the pass characteristic suitable for both the digital television signals and the analog television signals can be obtained.

According to the television tuner of this embodiment as mentioned above, since the resonant frequency of the first resonant circuit is substantially equal to the resonant frequency of the second resonant circuit and the capacitance of the first capacitor C1 is smaller than the capacitance of the second capacitor C2, the first resonant circuit has lower frequency selectivity Q and wider bandwidth and thus the pass characteristic suitable for receiving the digital television signals, and also the second resonant circuit has higher frequency selectivity Q and narrower bandwidth and thus the pass characteristic suitable for receiving the analog television signals. Therefore, since the IF tuning circuit 19 has the pass characteristic which is a combination of the pass characteristic of the first resonant circuit suitable for receiving the digital television signals and the pass characteristic of the second resonant circuit suitable for receiving the analog television signals, the IF tuning circuit can receive both digital television signals and analog television signals without degrading the receiving performance.

Further, since the IF tuning circuit 19 is configured to be a combination of the first resonant circuit and the second resonant circuit, the intermediate-frequency tuning circuit can be downsized and the circuit configuration thereof can be also simplified by a reduction in the number of components, in comparison with the circuit configuration in the intermediate-frequency tuning circuit switched by a switch or the like.

Further, frequency selectivity Q of the second resonant circuit can be adjusted by varying resistance values of the bias resistor R. Frequency selectivity Q can be made lower by rendering resistance values of the bias resistor R larger, and frequency selectivity Q can be made higher by rendering resistance values of the bias resistor R small. By doing so, it is possible to partially adjust the bandwidth of the pass characteristic of a portion in which the IF tuning circuit 19 is steeply protruded. In this case, the bias resistor R may be constituted by a variable resistive element.

Furthermore, in this embodiment, the first capacitive element and the second capacitive element according to the invention are constituted by capacitors, but may be constituted by variable capacitive elements of a varactor diode or the like in place of the capacitors.

As described above, the invention provides a television tuner being capable of making the circuit configuration simple, and capable of receiving both digital television signals and analog television signals without degrading the receiving performance.

It should be understood by those skilled in the art that various modifications, combinations, sub-combinations and alterations may occur depending on design requirements and other factors insofar as they are within the scope of the appended claims of the equivalents thereof.

## Claims

1. A television tuner capable of receiving digital television signals and analog television signals, comprising:
a mixer circuit (17) converting the received television signals into signals of an intermediate-frequency band, and
an intermediate-frequency tuning circuit (19) being connected to a rear end of the mixer circuit (17) and set to a tuning frequency corresponding to a reception channel,
wherein the intermediate-frequency tuning circuit (19) includes:
a first resonant circuit configured to have a first capacitance and to have a resonant frequency set in the intermediate-frequency band, and
a second resonant circuit configured to have a second capacitance and to have a resonant frequency set substantially equal to that of the first resonant circuit, and
wherein the first capacitance is smaller than the second capacitance.

2. The television tuner according to claim 1, wherein the mixer circuit (17) has a pair of balance output terminals,
wherein the first resonant circuit is constituted by the first capacitance connected between the pair of balance output terminals, and a series-connected circuit of first and second inductors connected in parallel to the first capacitance, a connection point between the first inductor and the second inductor being grounded in a high-frequency manner, and
wherein the second resonant circuit is constituted by the first inductor, and the second capacitance connected in parallel to the first inductor.

3. The television tuner according to claim 2, wherein
an inductance value of the first inductor is smaller than an inductance value of the second inductor.

4. The television tuner according to any one of claims 1 to 3, wherein the second resonant circuit has a resistive element setting frequency selectivity of the second resonant circuit.
